# EUROPEAN PATENT APPLICATION

(11) **EP 0 616 367 A1**
(43) Date of publication of application: **21.09.1994**
(21) Application number: 94301870.5
(22) Date of filing: 16.03.1994
(51) Int. Cl.: H01L 23/498

(54) **Lead structure and lead connecting method for semiconductor device**

(30) Priority: 17.03.1993 JP 57237/93
(71) Applicant: International Business Machines Corporation, Armonk, N.Y. 10504 (US)
(72) Inventor: Tsukada, Yutaka, Koga-gun, Shiga-ken (JP); Kobayakawa, Yasukazu, Koga-gun, Shiga-ken (JP); Maeda, Yoji, Koga-gun, Shiga-ken (JP); Tsuchita, Shuhei, Kusatsu-shi, Shiga-ken (JP)
(74) Representative: Moss, Robert Douglas

(57) **Abstract**

There is provided an electrically connecting structure of a semiconductor device and a method for forming such connecting structures that allow the reliable and easy electrical connection and simultaneous mechanical connection of a tab on a substrate having an IC chip mounted thereon to an electrode on the printed circuit board by using a plurality of fine lead wires.

A lead wire 120 is fixed at three portions, (the top, the side, and the bottom) of the substrate 100 with resin tapes 130, 132, and 134. The lead wire 120, when fixed on the substrate, is bent in such a manner that the lead wire 120 has a curved projection that projects from a plane coplanar with the bottom of the substrate. At this projection, the lead wire 120 is electrically connected to an electrode 115 on the printed circuit board 110 with solder or a conductive bonding agent 140. At the same time, the substrate and the printed circuit board are mechanically connected with each other.

## Description

### SPECIFICATION

### Field of the Invention

The present invention relates to electrical connecting structures for a semiconductor device and to methods for forming such connecting structures, and more particularly to a structure for electrically connecting an electrode on a substrate having an IC chip mounted thereon to an electrode on a printed circuit board for carrying the substrate.

### Prior Art

Highly integrated IC chips such as LSI's and VLSI's are usually electrically connected to the electrode on a substrate with wire bonding or flip chip bonding, and disposed on the substrate. Figure 5 is a view showing one example of a substrate having an IC chip placed thereon. The substrate 40 is generally referred to as a module substrate. On a thin plate having resin, ceramic, or metal as the base, a wiring pattern including an electrode for an IC chip 50 is formed. The wiring pattern on the substrate has an electrode group 70, usually called a "tab," which surrounds the periphery of substrate. Using this tab 70, the substrate is electrically connected to the electrode on the printed circuit board.

The tab on the substrate is electrically connected to the electrode on the printed circuit board, usually with a lead wire. In other words, both ends of the lead wire are disposed in such a manner that the ends surround the side part of the external periphery of the substrate. Both ends of the lead wire are connected with solder or a conductive bonding agent. These connections are carried out on a wire-by-wire basis. This electrically connects and simultaneously mechanically fixes the substrate with the electrode part on the printed circuit board.

As an example using a lead wire, PUPA 3-201545 discloses a semiconductor device which uses a lead wire for electrically connecting an electrode on the substrate having an IC chip mounted thereon with an external electrode. In this case, the lead wire has a circular projection with respect to the plane of the bottom part of the substrate, the projection serving to electrically connect with the electrode part on the printed circuit board. The electrode part on the substrate is electrically connected to the lead wire with a conductive bonding agent.

In addition, IBM Technical Disclosure Bulletin, Vol. 30, No. 3, August, 1987 also discloses a semiconductor device which uses a lead wire for electrically connecting an electrode part of the substrate having an IC chip mounted thereon to an external electrode. In this case, the lead wire has a circular projection with respect to the plane of the bottom part of the substrate in such a manner that the lead wire covers the side of the external periphery of the substrate, the projection serving to electrically connect with the electrode part on the printed circuit board. In this case the lead wire is fixed to the substrate at two positions, the top of the substrate and the bottom thereof.

As highly integrated IC chips such as LSI's and VLSI's have very many electrical input/output parts, the number of tab electrodes on the substrate increases in accordance with the large number of the input parts, and can even reach into the hundreds. On the other hand, the size of the substrate is restricted by the size of the printed circuit board on which the substrate is mounted. Preferably,the size of the substrate is minimized as much as possible. Consequently, in accordance with the increase in the integration of IC chips, the spaces between tab electrodes are narrowed down. Likewise, the spaces between lead wires must be narrowed down and the thickness of the lead wires must be reduced.

Reducing the thickness of the lead wire and narrowing the spaces between lead wires produces the following problem. Namely, the strength of the lead wire decreases due to the reduced thickness of the lead wire, thereby allowing easier deformation of the lead wire by external force. Consequently, in the process of placing the lead wire onto the substrate, adjacent lead wires contact each other by mistake or the spaces between the lead wires become irregular. In addition, as in the conventional example, electrical connection of the lead wire with an electrode on the printed circuit board, via a circular projection of the lead wire results in an irregular height of this projection with respect to the plane of the bottom of the substrate, thereby producing a portion where the lead wire cannot be electrically connected with the electrode part on the printed circuit board. The methods described in the above PUPA 3-201545 and IBM Technical Disclosure Bulletin, Vol. 30, No. 3, August, 1987 do not provide any effective means to overcome the above problem.

PUPA 4-79472 discloses a lead wire fixed with a tape for eliminating irregularity in the size of spaces between the lead wires. However, the lead wire in this case is manufactured integrally with electronic component in advance. One end of the lead line extending from the side of the electronic component is just electrically connected with the electrode on the printed circuit board with solder.

### Summary of the Invention

According to a first aspect of the invention, there is provided an electrical connecting structure for connecting an IC package and a printed circuit board, comprising:
a substrate on which an IC chip is mounted, having electrical connector pads for electrical connection to said chip; and
a plurality of lead wires for electrically connecting said electrical connector pads of the substrate to said electrical connector pads of said printed circuit board, characterised in that each of said plurality of lead wires are attached to the top, side, and bottom surfaces of said substrate, each of said plurality of lead wires having a projection at the bottom surface of said substrate for electrically connecting to said connector pads of said printed circuit board.

In a second aspect, the invention provides a method for connecting, by lead wires, electrical connector pads on a substrate having an IC chip mounted thereon and electrical connector pads on a printed circuit board for carrying the substrate, said method comprising the steps of:
attaching a plurality of lead wires to said substrate at at least three positions, said positions being at the top, the bottom, and the side surfaces of the substrate respectively;
electrically connecting with said plurality of lead wires a plurality of electrical connector pads disposed on said substrate; and
electrically connecting with said plurality of lead wires a plurality of electrodes disposed with equal spacing on said printed circuit board.

The present invention provides an electrical connecting structure for a semiconductor device and a method for forming such connecting structures, the structure enabling an extremely large number of fine lead wires to reliably and easily electrically connect, and simultaneously physically connect, a tab on the substrate with a highly integrated IC chip mounted thereon, and with an electrode on the printed circuit board.

The present invention sets forth an electrical connecting structure wherein, in an electrical connecting structure connecting, through lead wires, an electrode mounted on a substrate bearing an IC chip with an electrode on a printed circuit board providing the substrate, the lead wires are connected to the substrate at at least 3 points of the substrate (on the top, bottom, and side surfaces respectively), possessing a projection projecting from a plane coplanar with the bottom of the substrate, and are electrically connected in this projection to the electrode on the printed circuit board.

Furthermore, the present invention preferably provides an electrical connecting structure for electrically connecting an electrode on a substrate and an electrode on a printed circuit board for carrying the substrate by using a plurality of equally spaced lead wires, wherein both ends of said plurality of equally-spaced lead wires and at least one position therebetween are fixed with a resin tape, said fixed positions being joined with the top, the bottom and side of said substrate, each of said lead wires having a projection that projects from a plane coplanar with the bottom of said substrate, said projection serving as a position for electrically connecting said plurality of equally-spaced electrodes on the substrate with said plurality of equally-spaced electrodes on the printed circuit board.

### Specific Description

The invention will now be described in more detail by way of example, with reference to the accompanying drawings in which:
Figure 1 is a view showing one embodiment of a substrate with an electrical connecting structure according to the present invention;
Figure 2 is a view showing the cap 20 of the substrate shown in Figure 1 in an open state;
Figure 3 is a sectional view taken along line 2-2' of Figure 2 showing the manner of connection between the lead wire 30 and the substrate;
Figure 4 is a view showing one embodiment of a lead wire according to the invention before being placed on the substrate; and
Figure 5 is a view showing a substrate on which a general IC chip is mounted.

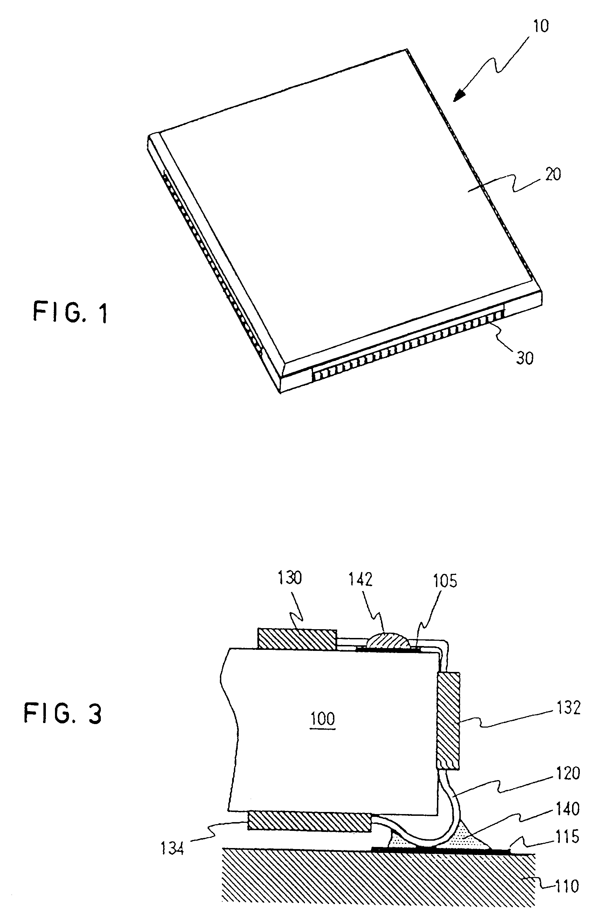

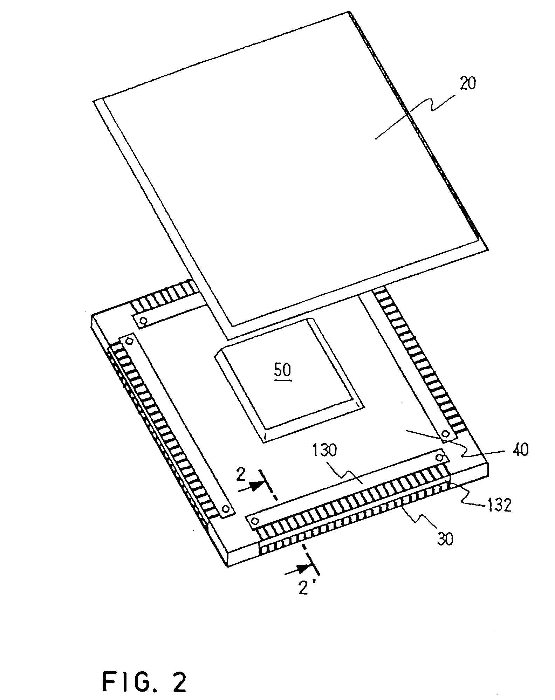

The present invention will be detailed hereinbelow in conjunction with Figures 1 through 4. Figure 1 is an overall view of a substrate having an electrically connecting structure of the present invention. The substrate 10 has a protective cap 20 and a lead wire 30 attached to each of the four sides of the substrate. Figure 2 is an overall view showing the substrate with protective cap 20 open. An IC chip 50 is mounted in the central portion of the substrate. The electrode pad on the IC chip and an electrode on the substrate are electrically connected with each other with wire bonding, or flip chip bonding. The electrode on the substrate is further connected by the wiring pattern on the interior of the substrate to the tab, which consists of an electrode group mounted on the peripheral part of the substrate. The wiring pattern may be mounted on the surface of the substrate, as shown in Figure 5. The lead wire 3 is fixed on the surface of the substrate and the side thereof with the resin tape 130 and 132.

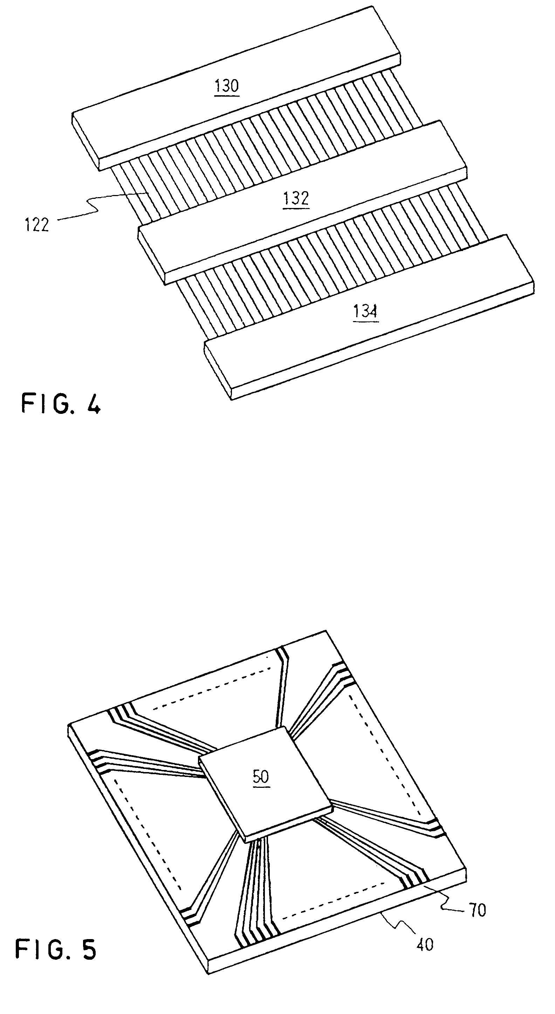

Figure 3 is a sectional view taken along line 2-2' of Figure 2 which details the connection between the lead wire 30 and the substrate. Referring to Figure 3, the lead wire 120 is fixed at three portions, the surface of the substrate 100, the side, and the bottom with a resin tape, such as polyimide tape 130, 132, and 134. The lead wire is fixed with resin tape through a heat-resistant agent applied on the tape in advance, or by coating the heat-resistant agent on the tape in the process of fixing the tape. The lead wire 120 is bent in such a manner that the wire has a circular projection that projects from a plane coplanar with the bottom part of the substrate when it is fixed on the substrate. The lead wire 120 is electrically connected with the electrode 115 on the printed circuit board 110 at the projection. Simultaneously, the substrate is mechanically connected with the printed circuit board. The substrate and the board are connected with solder or a conductive bonding agent 140. In the same manner, the lead wire 120 and the tab 105 on the substrate are electrically connected with solder or a conductive bonding agent 142.

The connection shown in Figure 3 is carried out on all the lead wires 30 shown in Figure 2 and Figure 3. In this case, as the height of the projection of the lead wire varies according to the position of the substrate, in places where it is low, it will be too far from the projection of the lead wire and the electrode on the printed circuit board. This will make it impossible to provide an electrical connection with solder or the like. Consequently, it is very important that the projection of the all the lead wires have as uniform a height as possible with respect to the plane of the bottom part of the substrate and that the substrate and the printed circuit board are approximately parallel to each other.

Figure 4 shows one example of the lead wire before being placed on the substrate. This lead wire has 504 lead wires with a pitch of 0.3 mm for use in a standard flat pack module. This lead wire is attached to each of the four sides of the module substrate. The lead wire is made of copper and is fixed at equal intervals with polyimide tape 130, 132, and 134. The width of one lead wire is about 0.15 mm while the space between lead wires is about 0.15 mm. The number of lead wires is 126. A method for manufacturing a connection structure using this lead wire as shown in Figure 3 will be detailed below.

The lead wire shown in Figure 4 is deformed with a pattern in accordance with the configuration of the side of the substrate on which the lead wire shown in Figure 3 is mounted. In other words, the lead wire is bent in such a manner that the lead wire has a circular projection that projects from a plane coplanar with the bottom of the substrate between the polyimide tapes 132 and 134. In the subsequent process, the polyimide tape 134 is fixed on the bottom of the substrate while the polyimide tape 132 is fixed on the side of the substrate. They are fixed with a heat-resistant bonding agent attached on the tape in advance or with the application of the heat-resistant bonding agent in the fixing process. The reason for using the heat-resistant bonding agent is that the tape can be prevented from coming off when soldering or a high temperature aging is performed in the subsequent process.

The lead wire is fixed at equal intervals with the polyimide tape 132 and 134. As long as the tapes 132 and 134 are fixed accurately at predetermined positions on the substrate, the spaces between the lead wires do not become irregular. The fixing position of the tape 134 on the bottom of the substrate is predetermined so that the projection of the lead wire has a predetermined height with respect to a plane coplanar with the bottom of the substrate. Fixing the tape 134 forms the projection of all the lead wires simultaneously, with the result that the height of the projection does not become irregular, but rather, is uniform.

In the next process, the polyimide tape 130 is fixed on the surface of the substrate. The tape is fixed thereon in the same manner as in the case of the polyimide tape 134. Then the tab 105 on the surface of the substrate is connected to the lead wire with solder 140. After applying the soldering paste on the tab from above the lead wire, or printing by screen printing before fixing the lead wire with the polyimide tape 130, soldering is performed by heating the whole substrate with a reflow furnace. Soldering dip may be used instead.

In the last process, the projection on the lead wire is connected to the electrode part on the printed circuit board. After soldering paste is screen-printed onto the electrode part of the printed circuit board, the substrate on which the lead wire is fixed is placed at a predetermined position. Each projection of lead wire is soldered (by heating) to the electrode on the printed circuit board to which it corresponds. When the substrate is placed on the printed circuit board, the lead wire can be elastically deformed in the direction vertical to each of the substrates, so even if the printed circuit board is bent or the height of the printed soldering paste is not uniform, there is little possibility of soldering failure.

Incidentally, the fixation of the lead wire onto the substrate is not limited to the above procedure. For example, the polyimide tape 130 can be initially fixed on the surface of the substrate, and after soldering the tab 105 and the lead wire on the surface of the substrate, the polyimide tapes 132 and 134 may be fixed on the side part and the bottom of the substrate.

An electrical connecting structure for a semiconductor device and a method therefor in accordance with the present invention allows reliable and easy electrical connection and simultaneous mechanical connection of an electrode on a substrate having a highly integrated IC chip mounted thereon to an electrode on the printed circuit board, using an extremely large number of fine lead wires.

## Claims

1. An electrical connecting structure for connecting an IC package and a printed circuit board, comprising:
a substrate on which an IC chip is mounted, having electrical connector pads for electrical connection to said chip; and
a plurality of lead wires for electrically connecting said electrical connector pads of the substrate to electrical connector pads of said printed circuit board, characterised in that each of said plurality of lead wires are attached to the top, side, and bottom surfaces of said substrate, each of said plurality of lead wires having a projection at the bottom surface of said substrate for electrically connecting to said connector pads of said printed circuit board.

2. An electrical connecting structure according to claim 1 wherein said projection of said lead wire comprises a curve formed between parts of said lead wire that adjoin the bottom and side of said substrate.

3. An electrical connecting structure according to claim 2 wherein said plurality of lead wires are attached to said substrate such that they are disposed with an equal spacing of 0.5mm or less and such that said projections project a uniform distance from the substrate.

4. An electrical connecting structure according to any one of claims 1 to 3 wherein said lead wire is attached to said substrate with a resin tape, a heat-resistant bonding agent or a combination of the tape and the bonding agent.

5. A semiconductor device comprising:
a substrate having an IC chip mounted thereon and a plurality of electrical connector pads for connection to said chip;
a printed circuit board for carrying said substrate, said printed circuit board having a plurality of correspondingly disposed electrical connector pads; and
a plurality of lead wires for electrically connecting said electrical connector pads on said substrate to said electrical connector pads on said printed circuit board;
characterised in that each of said lead wires is fixed to said substrate at at least three positions along its length, said three fixed positions being at the top, bottom, and side surfaces respectively of said substrate, each of said lead wires having a projection that projects from a plane coplanar with the bottom of said substrate, said projection serving for electrically connecting said plurality of electrical connector pads on the substrate with said plurality of electrodes on the printed circuit board.

6. A semiconductor device according to claim 5 wherein said plurality of lead wires are disposed at an equal spacing of 0.5 mm or less.

7. A semiconductor device according to claim 5 or claim 6 wherein said projection of said lead wire comprises a curve formed between the portions of said lead wires that adjoin the bottom and the side of said substrate.

8. A semiconductor device according to claim 7 wherein each of said projections of said lead wires have a uniform height with respect to a plane coplanar with the bottom of said substrate, said substrate and said printed circuit board being approximately parallel to each other.

9. A semiconductor device according to any one of claims 5 to 8 wherein said lead wire is attached to said substrate with a resin tape, a heat-resistant bonding agent or a combination of the tape and the bonding agent.

10. A method for connecting, by lead wires, electrical connector pads on a substrate having an IC chip mounted thereon and electrical connector pads on a printed circuit board for carrying the substrate, said method comprising the steps of:
attaching a plurality of lead wires to said substrate at at least three positions, said positions being at the top, the bottom, and the side surfaces of the substrate respectively;
electrically connecting with said plurality of lead wires a plurality of electrical connector pads disposed on said substrate; and
electrically connecting with said plurality of lead wires a plurality of electrodes disposed with equal spacing on said printed circuit board.

11. A method for connecting according to claim 10, wherein the step of joining said plurality of lead wires to said substrate includes the process of bending said plurality of lead wires in accordance with the configuration of the side part of said substrate in such a manner that each of said plurality of lead wires has a projecting part that projects from a plane coplanar with the bottom of said substrate, which projecting part is suitable for connection to said electrical connector pads on said printed circuit board.

12. A method for electrical connection according to claim 10 or claim 11 wherein said plurality of lead wires are joined to said substrate at at least said three positions with resin tape, heat-resistant bonding agent, or a combination of resin tape and heat-resistant bonding agent.
